# EUROPEAN PATENT APPLICATION

(11) **EP 4 637 306 A1**
(43) Date of publication of application: **22.10.2025**
(21) Application number: 23903331.9
(22) Date of filing: 01.12.2023
(51) Int. Cl.: H10K 39/12, H01L 31/0468, H10K 30/40

(54) **PHOTOELECTRIC CONVERSION MODULE AND PHOTOELECTRIC CONVERSION MODULE MANUFACTURING METHOD**

(30) Priority: 15.12.2022 JP 2022200378
(71) Applicant: Panasonic Intellectual Property Management Co., Ltd., Kadoma-shi, Osaka 571-0057 (JP)
(72) Inventor: HIGUCHI, Hiroshi, Kadoma-shi, Osaka 571-0057 (JP)
(74) Representative: Grünecker Patent- und Rechtsanwälte PartG mbB
(86) International application number: PCT/JP2023/043190
(87) International publication number: WO 2024/128042

(57) **Abstract**

A photoelectric conversion module (1000) according to the present disclosure includes: a light-transmitting insulating substrate (100); a plurality of photoelectric conversion element groups (200) including a first photoelectric conversion element group (200a) and a second photoelectric conversion element group (200b) adjacent to each other, the plurality of photoelectric conversion element groups being disposed on a first principal surface (100a) of the light-transmitting insulating substrate (100); and a light-transmitting portion (300) disposed between the first and second photoelectric conversion element groups. The plurality of photoelectric conversion element groups are disposed in parallel along a second direction. The light-transmitting portion (300) includes a light-transmitting layer disposed on the light-transmitting insulating substrate (100). The light-transmitting portion (300) is composed of a first region in contact with the first photoelectric conversion element group, a second region in contact with the second photoelectric conversion element group, and a third region provided between the first region and the second region, the third region being in contact neither with the first photoelectric conversion element group nor with the second photoelectric conversion element group. The light-transmitting layer is disposed neither in the first region nor in the second region, and is disposed in the third region.

## Description

### TECHNICAL FIELD

The present invention relates to a photoelectric conversion module and a photoelectric conversion module manufacturing method.

### BACKGROUND ART

Integrated thin-film photoelectric conversion modules are known as photoelectric conversion modules. In an integrated thin-film photoelectric conversion module, thin films, such as an electrode layer and a photoelectric conversion layer, are stacked on a substrate and the stack of the thin films is divided by a plurality of dividing grooves to form a plurality of photoelectric conversion elements. The integrated thin-film photoelectric conversion module has an integrated structure in which these photoelectric conversion elements are connected to each other in series.

An integrated thin-film photoelectric conversion module as described above in which a plurality of photoelectric conversion elements are arranged on one substrate has a disadvantage in that a defect of one of the photoelectric conversion elements has an adverse impact on power output of the whole module. Therefore, for example, Patent Literature 1 proposes an inexpensive, high-power solar cell module maintaining cost efficiency and simplicity of the conventional integration style, the solar cell module being capable of being manufactured in a high production yield. The solar cell module disclosed in Patent Literature 1 has a structure in which a plurality of submodules each including a plurality of thin-film photoelectric conversion elements are disposed in a direction orthogonal to a direction of series connection in the submodule with a submodule dividing groove in between, the thin-film photoelectric conversion elements each being composed of a transparent electrode layer, a photoelectric conversion layer, and a metal electrode layer stacked in this order on a surface of a light-transmitting insulating substrate, the thin-film photoelectric conversion elements being electrically connected to each other.

Applying photoelectric conversion modules to construction materials, such as window glass, has also been proposed. For example, Patent Literature 2 proposes glass for windows, the glass including a solar cell.

### CITATION LIST

### Patent Literature

Patent Literature 1: JP H11(1999)-312816A
Patent Literature 2: JP H4(1992)-360983 A

### SUMMARY OF INVENTION

### Technical Problem

The present disclosure provides a photoelectric conversion module based on the conventional integration style that can achieve high power output and providing improved visibility.

### Solution to Problem

A photoelectric conversion module according to the present disclosure includes:
a light-transmitting insulating substrate;
a plurality of photoelectric conversion element groups including a first photoelectric conversion element group and a second photoelectric conversion element group adjacent to each other, the plurality of photoelectric conversion element groups being disposed on a first principal surface of the light-transmitting insulating substrate; and
a light-transmitting portion disposed between the first photoelectric conversion element group and the second photoelectric conversion element group, wherein
the first photoelectric conversion element group and the second photoelectric conversion element group each include a plurality of photoelectric conversion elements disposed along a first direction, the plurality of photoelectric conversion elements being electrically connected to each other in series,
the plurality of photoelectric conversion element groups are disposed in parallel along a second direction that is different from the first direction,
the light-transmitting portion includes a light-transmitting layer disposed on the first principal surface of the light-transmitting insulating substrate,
the photoelectric conversion element includes a light-transmitting electrode disposed on the first principal surface of the light-transmitting insulating substrate, a counter electrode disposed to face the light-transmitting electrode, and a photoelectric conversion layer disposed between the light-transmitting electrode and the counter electrode,
the light-transmitting portion is composed of a first region in contact with the first photoelectric conversion element group, a second region in contact with the second photoelectric conversion element group, and a third region provided between the first region and the second region, the third region being in contact neither with the first photoelectric conversion element group nor with the second photoelectric conversion element group,
the light-transmitting layer is disposed neither in the first region nor in the second region, and
the light-transmitting layer is disposed in the third region.

### Advantageous Effects of Invention

The present disclosure provides a photoelectric conversion module based on a conventional integration style that can achieve high power output and providing improved visibility.

### BRIEF DESCRIPTION OF DRAWINGS

FIG. 1 is a plan view schematically showing the configuration of a photoelectric conversion module according an embodiment of the present disclosure.
FIG. 2 is a cross-sectional view of the photoelectric conversion module shown in FIG. 1 and viewed at a position indicated by line II-II in an arrow direction.
FIG. 3 is a cross-sectional view of the photoelectric conversion module shown in FIG. 1 and viewed at a position indicated by line III-III in an arrow direction.
FIG. 4 is a cross-sectional view illustrating a relationship between a photoelectric conversion element group and a light-transmitting portion in the photoelectric conversion module according the embodiment of the present disclosure.
FIG. 5 is a cross-sectional view illustrating a relationship between a modification of a photoelectric conversion element group and a light-transmitting portion in the photoelectric conversion module according the embodiment of the present disclosure.
FIG. 6 is a cross-sectional view showing a modification of a light-transmitting layer in the photoelectric conversion module according the embodiment of the present disclosure.
FIG. 7A is an image of transmitting light through a first band-shaped region and a second band-shaped region of an evaluation sample on a light-emitting panel.
FIG. 7B is an image of an evaluation sample on a printed material on a light-emitting panel.
FIG. 7C is an image of a view on the other side of an evaluation sample through the evaluation sample.

### DESCRIPTION OF EMBODIMENTS

### <Findings on which the present disclosure is based>

It is known that in the case of an integrated thin-film photoelectric conversion module in which a plurality of photoelectric conversion elements are arranged on one substrate, the larger the area of the substrate, or the larger the area of each photoelectric conversion element, the greater impact a defect of one photoelectric conversion element has on power output of the whole module. Examples of the term "defect" of a photoelectric conversion element include, as described in Patent Literature 1, a short circuit between electrodes attributable to a pinhole, non-uniformity in current density between photoelectric conversion elements, and insufficient electrical separation between photoelectric conversion elements. A defect of one photoelectric conversion element results in a decrease in power output performance of the whole integrated module.

To suppress a decrease in power output performance of the whole module due to a defect of one photoelectric conversion element, a technique has been proposed in which a photoelectric conversion element group including a plurality of photoelectric conversion elements connected to each other in series is divided into a plurality of groups by a dividing groove(s) extending in the direction of series connection. That is, a photoelectric conversion module has been proposed in which a plurality of photoelectric conversion element groups are disposed in parallel in a direction orthogonal to the direction of the series connection in the photoelectric conversion element group. The module having this configuration can reduce an impact of a defect of one photoelectric conversion element on a decrease in power output of the whole module, and therefore can reduce a risk of a decrease in power output of the whole module, compared to a module having a configuration in which a photoelectric conversion element group is not divided by a dividing groove as described above.

Meanwhile, a technique for integrating a construction material, such as window glass, and a photoelectric conversion module in order to reduce an installation cost of the photoelectric conversion module and secure the installation area has been proposed recently. For integration with a construction material, such as window glass, requiring a daylighting function, photoelectric conversion modules are required to be configured such that the photoelectric conversion modules are less likely to interfere with daylighting and are capable of achieving the highest power output possible.

Therefore, as a result of intensive studies, the present inventor has found a new configuration in which a dividing groove as described above serves for daylighting, the dividing groove being provided to an integrated photoelectric conversion module to achieve high power output (i.e., a dividing groove provided to isolate photoelectric conversion element groups and extending in a direction of series connection in the photoelectric conversion element group).

However, as a result of further studies, the present inventor has newly found a disadvantage in that when a dividing groove as described above is directly used as a component for daylighting, daylighting can be ensured to a certain degree but the visibility is insufficient. The present inventor has also found out that a factor of decreasing the visibility is impairment of the smoothness of a surface of a light-transmitting insulating substrate in formation of the dividing groove.

On the basis of the above findings, the present inventor made intensive studies to overcome the above disadvantage of a light-transmitting insulating substrate in formation of the dividing groove and devised the photoelectric conversion module according to the present disclosure.

A photoelectric conversion module of the present disclosure includes:
a light-transmitting insulating substrate;
a plurality of photoelectric conversion element groups including a first photoelectric conversion element group and a second photoelectric conversion element group adjacent to each other, the plurality of photoelectric conversion element groups being disposed on a first principal surface of the light-transmitting insulating substrate; and
a light-transmitting portion disposed between the first photoelectric conversion element group and the second photoelectric conversion element group, wherein
the first photoelectric conversion element group and the second photoelectric conversion element group each include a plurality of photoelectric conversion elements disposed along a first direction, the plurality of photoelectric conversion elements being electrically connected to each other in series,
the plurality of photoelectric conversion element groups are disposed in parallel along a second direction that is different from the first direction,
the light-transmitting portion includes a light-transmitting layer disposed on the first principal surface of the light-transmitting insulating substrate,
the photoelectric conversion element includes a light-transmitting electrode disposed on the first principal surface of the light-transmitting insulating substrate, a counter electrode disposed to face the light-transmitting electrode, and a photoelectric conversion layer disposed between the light-transmitting electrode and the counter electrode,
the light-transmitting portion is composed of a first region in contact with the first photoelectric conversion element group, a second region in contact with the second photoelectric conversion element group, and a third region provided between the first region and the second region, the third region being in contact neither with the first photoelectric conversion element group nor with the second photoelectric conversion element group,
the light-transmitting layer is disposed neither in the first region nor in the second region, and
the light-transmitting layer is disposed in the third region.

As described above, in the photoelectric conversion module according to the present disclosure, the component corresponding to the above dividing groove in a conventional integration style serves as the light-transmitting portion and the light-transmitting portion is provided with the light-transmitting layer arranged on the light-transmitting insulating substrate. The photoelectric conversion module according to the present disclosure having this configuration is based on a conventional integration style that can achieve high power output and can provide improved visibility.

Additionally, in the photoelectric conversion module according to the present disclosure, on the first principal surface of the light-transmitting insulating substrate, the light-transmitting portion is composed of the first region in contact with a first photoelectric conversion element group, the second region in contact with a second photoelectric conversion element group, and the third region provided between the first region and the second region. The third region is in contact neither with the first photoelectric conversion element group nor with the second photoelectric conversion element group. The light-transmitting layer is disposed neither in the first region nor in the second region, and the light-transmitting layer is disposed in the third region. Because of this configuration, even if the light-transmitting layer includes a material having electrical conductivity (that is, regardless of the material of the light-transmitting layer), reliable isolation between the first photoelectric conversion element group and the second photoelectric conversion element group is achieved, and thus a reliable photoelectric conversion module can be achieved.

An embodiment of the present disclosure will be hereinafter described with reference to the drawings. The present disclosure is not limited to the following embodiment.

### <Embodiment of the present disclosure>

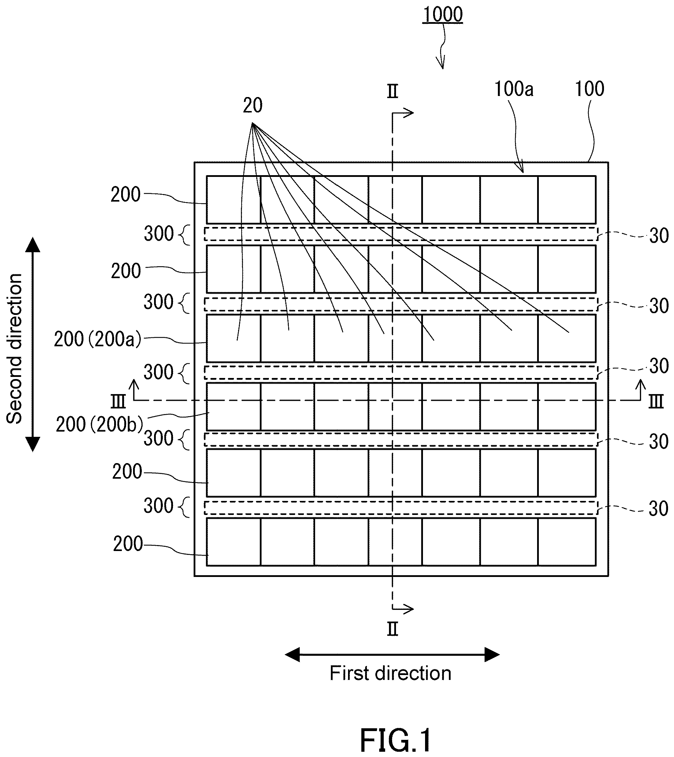

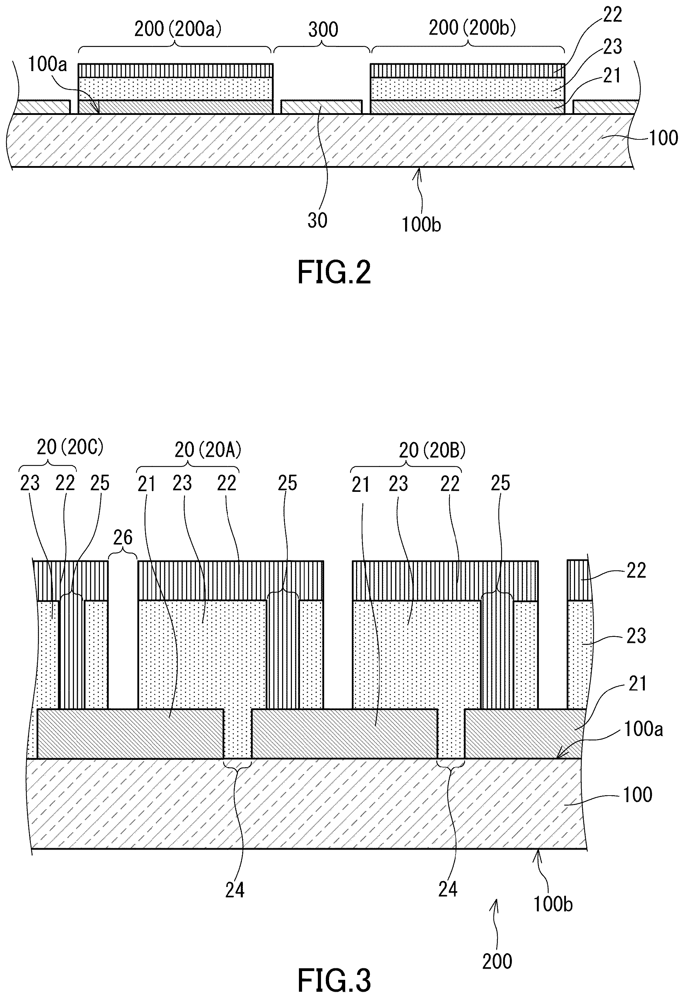

FIG. 1 is a plan view schematically showing the configuration of a photoelectric conversion module according an embodiment of the present disclosure. FIG. 2 is a cross-sectional view of the photoelectric conversion module shown in FIG. 1 and viewed at a position indicated by line II-II in an arrow direction. FIG. 3 is a cross-sectional view of the photoelectric conversion module shown in FIG. 1 and viewed at a position indicated by line III-III in an arrow direction.

As shown in FIGS. 1 to 3, a photoelectric conversion module 1000 according to the present embodiment includes a light-transmitting insulating substrate 100, a plurality of photoelectric conversion element groups 200 disposed on a first principal surface 100a of the light-transmitting insulating substrate 100, and a light-transmitting portion 300. The plurality of photoelectric conversion element groups 200 includes a first photoelectric conversion element group 200a and a second photoelectric conversion element group 200b adjacent to each other. The light-transmitting portion 300 is disposed between the first photoelectric conversion element group 200a and the second photoelectric conversion element group 200b. For example, the light-transmitting portion 300 can isolate the first photoelectric conversion element group 200a and the second photoelectric conversion element group 200b from each other. In the photoelectric conversion module 1000 according to the present embodiment, for example, a second principal surface 100b facing the first principal surface 100a of the light-transmitting insulating substrate 100 serves as a light-receiving surface, and light is incident on the photoelectric conversion module 1000 from the second principal surface 100b.

The first photoelectric conversion element group 200a and the second photoelectric conversion element group 200b each include a plurality of photoelectric conversion elements 20 disposed along a first direction and connected to each other in series along the first direction. For example, every photoelectric conversion element group 200 includes the plurality of photoelectric conversion elements 20 disposed along the first direction and connected to each other in series along the first direction. As shown in FIG. 3, the photoelectric conversion element 20 includes a light-transmitting electrode 21 disposed on the first principal surface 100a of the light-transmitting insulating substrate 100, a counter electrode 22 disposed to face the light-transmitting electrode 21, and a photoelectric conversion layer 23 disposed between the light-transmitting electrode 21 and the counter electrode 22.

As shown in FIG. 1, the plurality of photoelectric conversion element groups 200 are disposed in parallel along a second direction that is different from the first direction. That is, the plurality of photoelectric conversion element groups 200 are disposed in parallel in a direction different from the direction of the series connection of the photoelectric conversion elements 20 of the photoelectric conversion element group 200. The second direction may be, for example, orthogonal to the first direction.

As shown in FIGS. 1 and 2, the light-transmitting portion 300 includes a light-transmitting layer 30 disposed on the first principal surface 100a of the light-transmitting insulating substrate 100. The light-transmitting layer 30 is in contact with the first principal surface 100a of the light-transmitting insulating substrate 100. The visibility through the photoelectric conversion module 1000 is improved by providing the light-transmitting layer 30 to the light-transmitting portion 300. Improvement of the visibility through the photoelectric conversion module 1000 by providing the light-transmitting layer 30 to the light-transmitting portion 300 will be shortly described hereinafter. The detail will be described in the section (Light-transmitting portion and light-transmitting layer) below. The light-transmitting portion 300 is provided to isolate the first photoelectric conversion element group 200a and the second photoelectric conversion element group 200b from each other and impart light transmittancy to the photoelectric conversion module 1000. The light-transmitting portion 300 is obtained by forming a groove, for example, by laser etching, in the first direction, the photoelectric conversion element 20 formed of a laminate including the light-transmitting electrode 21, the photoelectric conversion layer 23, and the counter electrode 22, the laminate being disposed on the first principal surface 100a of the light-transmitting insulating substrate 100. This laser etching etches away a portion of the first principal surface 100a of the light-transmitting insulating substrate 100, impairing the smoothness of the first principal surface 100a. The light-transmitting layer 30 prevents such impairment of the smoothness. The prevention by the light-transmitting layer 30 is achieved, for example, by forming the light-transmitting electrode 21 on the entire first principal surface 100a and removing only both ends of the light-transmitting electrode between the photoelectric conversion element group 200a and the photoelectric conversion element group 200b adjacent to each other to the first surface 100a by etching to form the light-transmitting layer 30 shown in FIG. 2. Alternatively, the smoothness of the first principal surface 100a once impaired can be improved by disposing the light-transmitting layer 30 that is smooth on the first principal surface 100a. Hence, the light-transmitting layer 30 reduces scattering of light on the light-transmitting portion 300, and the visibility through the photoelectric conversion module 1000 is improved.

The first photoelectric conversion element group 200a and the second photoelectric conversion element group 200b may be electrically connected to each other in parallel. In the case where the first photoelectric conversion element group 200a and the second photoelectric conversion element group 200b are electrically connected to each other in parallel, even when either the first photoelectric conversion element group 200a or the second photoelectric conversion element group 200b includes a defective photoelectric conversion element 20, a decrease in power output of the whole module can be reduced by connecting that photoelectric conversion element group 200 to the other photoelectric conversion element group 200 formed of good photoelectric conversion elements 20 in parallel. The first photoelectric conversion element group 200a and the second photoelectric conversion element group 200b may be connected to each other in series. Alternatively, all photoelectric conversion element groups 200 included in the photoelectric conversion module 1000 may be connected to each other in parallel, may be connected to each other in series, or may be connected by a combination of series and parallel connections.

In the photoelectric conversion module 1000 according to the present embodiment, every pair of the photoelectric conversion element groups 200 adjacent to each other and included in the plurality of photoelectric conversion element groups 200 may satisfy the above relationship between the first photoelectric conversion element group 200a and the second photoelectric conversion element group 200b. That is, the plurality of photoelectric conversion element groups 200 may be disposed in parallel along the second direction with the light-transmitting portion 300 in between.

Although the photoelectric conversion module 1000 shown in FIG. 1 has a configuration in which six photoelectric conversion element groups 200 are provided and seven photoelectric conversion elements 20 are connected to each other in series in each photoelectric conversion element group 200, the number of photoelectric conversion element groups 200 and the number of photoelectric conversion elements 20 are not limited to these. The number of photoelectric conversion element groups 200 formed on one light-transmitting insulating substrate and the number of photoelectric conversion elements 20 included in one photoelectric conversion element group 200 can be selected as appropriate depending on, for example, the size of the photoelectric conversion module 1000 and the intended power output.

The components of the photoelectric conversion module 1000 will be specifically described hereinafter.

### (Photoelectric conversion element group)

As shown in FIG. 1, the plurality of photoelectric conversion element groups 200 are disposed on the light-transmitting insulating substrate 100. The photoelectric conversion element groups 200 are in parallel along the second direction with a given distance in between.

The photoelectric conversion element group 200 includes the plurality of photoelectric conversion elements 20 disposed along the first direction and electrically connected to each other in series.

As shown in FIG. 3, the photoelectric conversion element 20 includes the light-transmitting electrode 21 disposed on the first principal surface 100a of the light-transmitting insulating substrate 100, the counter electrode 22 disposed to face the light-transmitting electrode 21, and the photoelectric conversion layer 23 disposed between the light-transmitting electrode 21 and the counter electrode 22. For example, the photoelectric conversion element group 200 has a configuration in which a photoelectric conversion element including a light-transmitting electrode, a photoelectric conversion layer, and a counter electrode is divided into a plurality of unit cells (namely, the photoelectric conversion element 20) and the unit cells are connected in series. The light-transmitting electrode is divided into a plurality of the light-transmitting electrodes 21 by a first dividing groove 24. The photoelectric conversion layer is divided into a plurality of the photoelectric conversion layers 23 by a second dividing groove 25. The counter electrode is divided into a plurality of the counter electrodes 22 by a third dividing groove 26. The third dividing groove 26 may be formed also in the photoelectric conversion layer 23. The first dividing groove 24, the second dividing groove 25, and the third dividing groove 26 may be formed approximately parallel to each other. Widths of the first dividing groove 24, the second dividing groove 25, and the third dividing groove 26 are not limited to particular widths; the first dividing groove 24, the second dividing groove 25, and the third dividing groove 26 each desirably have, for example, a width of 2 µm or more to secure sufficient electrical insulation.

Each of the photoelectric conversion elements 20 has a laminate structure in which the light-transmitting electrode 21, the photoelectric conversion layer 23, and the counter electrode 22 are stacked in this order. The second dividing groove 25 is disposed so as to overlap the light-transmitting electrode 21 when viewed in a direction perpendicular to a surface of the light-transmitting insulating substrate 100. The counter electrode 22 of the adjacent photoelectric conversion element 20 is disposed in the second dividing groove 25. The light-transmitting electrode 21 is electrically connected to the counter electrode 22 of the adjacent photoelectric conversion element 20 in the second dividing groove 25. That is, the second dividing groove 25 functions as a groove for connecting elements.

Electrical connection of the photoelectric conversion elements 20 will be described hereinafter using one (a first photoelectric conversion element 20A) of the photoelectric conversion elements 20, a second photoelectric conversion element 20B adjacent to the first photoelectric conversion element 20A, and a third photoelectric conversion element 20C adjacent to the first photoelectric conversion element 20A, as shown in FIG. 3.

The light-transmitting electrode 21 of the first photoelectric conversion element 20A is electrically connected to the counter electrode 22 of the third photoelectric conversion element 20C, out of the second photoelectric conversion element 20B and the third photoelectric conversion element 20C adjacent to the first photoelectric conversion element 20A on opposite sides. The counter electrode 22 of the first photoelectric conversion element 20A is electrically connected to the light-transmitting electrode 21 of the second photoelectric conversion element 20B. In this manner, the photoelectric conversion elements 20 are connected to each other in series. Additionally, in the photoelectric conversion element group 200 having an integrated structure including these photoelectric conversion elements 20, the photoelectric conversion layer 23 is in contact with the light-transmitting electrode 21 in the first dividing groove 24.

Though not shown in FIG. 3, in the photoelectric conversion element 20, a carrier transfer layer may be provided between the light-transmitting electrode 21 and the photoelectric conversion layer 23 and between the photoelectric conversion layer 23 and the counter electrode 22. For example, the photoelectric conversion element 20 may further include an electron transport layer disposed between the light-transmitting electrode 21 and the photoelectric conversion layer 23 and a hole transport layer disposed between the photoelectric conversion layer 23 and the counter electrode 22. Only one of the electron transport layer and the hole transport layer may be provided, or both the electron transport layer and the hole transport layer may be provided. The electron transport layer may be disposed between the photoelectric conversion layer 23 and the counter electrode 22, and the hole transport layer may be disposed between the light-transmitting electrode 21 and the photoelectric conversion layer 23. An example will be hereinafter described where the carrier transfer layer disposed between the light-transmitting electrode 21 and the photoelectric conversion layer 23 is the electron transport layer and the carrier transfer layer disposed between the photoelectric conversion layer 23 and the counter electrode 22 is the hole transport layer. A porous layer may be arranged between the electron transport layer and the photoelectric conversion layer 23.

### (Light-transmitting portion and light-transmitting layer)

As described above, the light-transmitting portion 300 is provided to isolate the first photoelectric conversion element group 200a and the second photoelectric conversion element group 200b from each other and impart light transmittancy to the photoelectric conversion module 1000. A width of the light-transmitting portion 300, i.e., a length of the light-transmitting portion 300 in the second direction, can be determined as appropriate taking account of various factors, such as the intended amount of daylight, the intended power output of the photoelectric conversion module 1000, and the size of the photoelectric conversion module 1000. For example, the length of the light-transmitting portion 300 in the second direction may be 40 µm or more.

The light-transmitting portion 300 and the light-transmitting layer 30 transmit, for example, 10% or more of light with a wavelength in the range from 200 nm to 2000 nm. The light-transmitting portion 300 and the light-transmitting layer 30 can transmit, for example, light from the visible region to the near-IR region.

The light-transmitting layer 30 may be formed of the same material as that of the light-transmitting electrode 21. In this case, the light-transmitting layer 30 can be formed using a thin film for light-transmitting electrode formation which is formed on the light-transmitting insulating substrate 100 for formation of the light-transmitting electrode 21 of the photoelectric conversion element 20. Specifically, to form the photoelectric conversion element 20, a laminate in which the thin film for light-transmitting electrode formation, a thin layer for photoelectric conversion layer formation, and a thin film for counter electrode formation are stacked is formed, and then, in a region where the light-transmitting layer 30 is to be formed, the other thin films of the laminate excluding the thin film for light-transmitting electrode formation are removed, for example, using a laser. In this case, the light-transmitting layer 30 can be produced by a process for producing the photoelectric conversion element 20 without separately performing a process for producing the light-transmitting layer 30. The material of the photoelectric conversion layer 23 commonly has significantly different thermal properties from those of the material of the light-transmitting electrode 21, and evaporates at a temperature lower than the evaporation temperature of the material of the light-transmitting electrode 21. For example, when a photoelectric conversion material included in the photoelectric conversion layer 23 is a perovskite compound, the material of the photoelectric conversion layer 23 can be removed at a much lower temperature. Therefore, it is easy to remove the other thin films from the laminate, leaving only the thin film for light-transmitting electrode formation. Moreover, the smoothness of a surface of the thin film for light-transmitting electrode formation does not greatly decrease and light scattering which greatly decreases the visibility is less likely to occur, the surface being exposed by removing the other thin films of the laminate excluding the thin film for light-transmitting electrode formation.

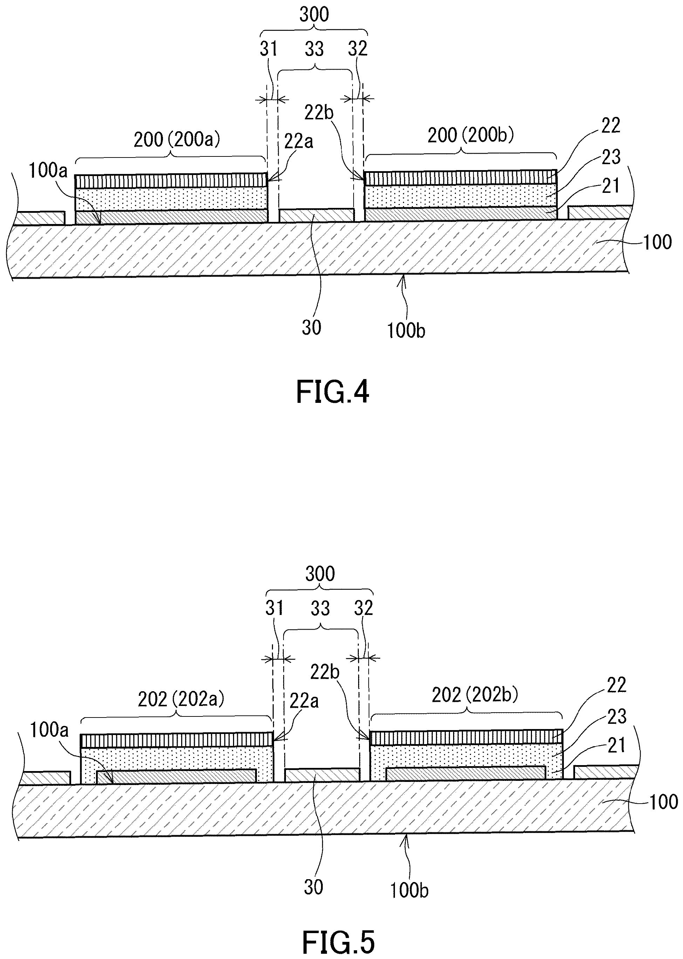

The photoelectric conversion element group 200 and the light-transmitting portion 300 satisfy the following relationship. FIG. 4 is a cross-sectional view illustrating the relationship between the photoelectric conversion element group 200 and the light-transmitting portion 300 in the photoelectric conversion module 1000 according the embodiment of the present disclosure. On the first principal surface 100a of the light-transmitting insulating substrate 100, the light-transmitting portion 300 is, as shown in FIG. 4, composed of a first region 31 in contact with the first photoelectric conversion element group 200a, a second region 32 in contact with the second photoelectric conversion element group 200b, and a third region 33 provided between the first region 31 and the second region 32. The third region 33 is in contact neither with the first photoelectric conversion element group 200a nor with the second photoelectric conversion element group 200b. The light-transmitting layer 30 is disposed neither in the first region 31 nor in the second region 32, and the light-transmitting layer 30 is disposed in the third region 33. Owing to this configuration, even when the light-transmitting layer 30 is, for example, formed of the same material as that of the light-transmitting electrode 21 and has electrical conductivity, reliable isolation between the first photoelectric conversion element group 200a and the second photoelectric conversion element group 200b can be achieved.

The first region 31 may be a region, for example, from an end face 22a of the counter electrode 22 of the first photoelectric conversion element group 200a to a position 20 µm or more apart from the end face 22a, the end face 22a facing the first region 31. The second region 32 may be a region, for example, from an end face 22b of the counter electrode 22 of the second photoelectric conversion element group 200b to a position 20 µm or more apart from the end face 22b, the end face 22b facing the second region 32. In this configuration, the light-transmitting layer 30 is disposed 20 µm or more apart from both the end face 22a of the first photoelectric conversion element group 200a and the end face 22b of the second photoelectric conversion element group 200b. Hence, the reliability of isolation between the first photoelectric conversion element group 200a and the second photoelectric conversion element group 200b can further be increased.

The first region 31 may be a region, for example, from the end face 22a of the counter electrode 22 of the first photoelectric conversion element group 200a to a position 1 mm or less apart from the end face 22a, the end face 22a facing the first region 31. The second region 32 may be a region, for example, from the end face 22b of the counter electrode 22 of the second photoelectric conversion element group 200b to a position 1 mm or less apart from the end face 22b, the end face 22b facing the second region 32. In this configuration, the light-transmitting layer 30 is disposed 1 mm or less apart from both the end face 22a of the first photoelectric conversion element group 200a and the end face 22b of the second photoelectric conversion element group 200b. In the case of this configuration, in the light-transmitting portion 300, the first region 31 and the second region 32 where the light-transmitting layer 30 is not disposed do not have too large a width, and therefore light scattering that occurs in the first region 31 and the second region 32 on the first principal surface 100a of the light-transmitting insulating substrate 100 can be reduced. Consequently, the visibility through the photoelectric conversion module 1000 can be improved further.

The distance from the end face 22a of the counter electrode 22 of the first photoelectric conversion element group 200a is a distance measured from a portion of the end face 22a, the portion being closest to the first region 31, the end face 22a facing the first region 31. The distance from the end face 22b of the counter electrode 22 of the second photoelectric conversion element group 200b is a distance measured from a portion of the end face 22b, the portion being closest to the second region 32, the end face 22b facing the second region 32. It should be noted that as in the photoelectric conversion element group 200 shown in FIG. 4, an end face of the photoelectric conversion element group may be formed of a lateral side of the light-transmitting electrode 21, a lateral side of the photoelectric conversion layer 23, and a lateral side of the counter electrode 22. FIG. 5 is a cross-sectional view showing a relationship between a modification of the photoelectric conversion element group and the light-transmitting portion 300 in the photoelectric conversion module 1000 according the embodiment of the present disclosure. The photoelectric conversion element group may have, as in a photoelectric conversion element group 202 shown in FIG. 5, a configuration in which a lateral side of the light-transmitting electrode 21 is covered with the photoelectric conversion layer 23 and the counter electrode 22 is provided on the photoelectric conversion layer 23.

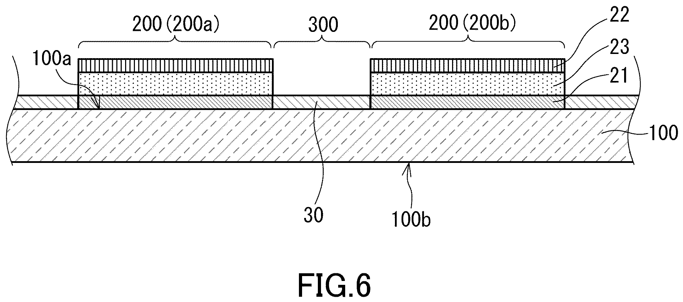

The light-transmitting layer 30 may be formed of a material different from that of the light-transmitting electrode 21. For example, when the light-transmitting layer 30 is formed of a light-transmitting insulating material, the light-transmitting layer 30 may be in contact with the first photoelectric conversion element group 200a and the second photoelectric conversion element group 200b. Therefore, the light-transmitting layer 30 can be formed in the entire light-transmitting portion 300. FIG. 6 is a cross-sectional view showing a modification of the light-transmitting layer 30 in the photoelectric conversion module 1000 according the embodiment of the present disclosure. When the light-transmitting layer 30 is formed of a light-transmitting insulating material, the light-transmitting layer 30 may be disposed in the entire light-transmitting portion 300, as shown in FIG. 6. This light-transmitting layer 30 can be formed, for example, by the following method. To form the photoelectric conversion element 20, a laminate in which the thin film for light-transmitting electrode formation, the thin film for photoelectric conversion layer formation, and the thin film for counter electrode formation are stacked is produced, and a portion of the laminate in a region where the light-transmitting layer 30 is to be formed is removed from the laminate. On the light-transmitting insulating substrate 100 having the first principal surface 100a exposed by removing the laminate, the light-transmitting layer 30 is formed using the light-transmitting insulating material, for example, by chemical vapor deposition or sputtering. Even when the first principal surface 100a of the light-transmitting insulating substrate 100 is roughened by the above removal of the laminate, the thus-formed light-transmitting layer 30 fills the first principal surface 100a and thus can improve the smoothness of the first principal surface 100a. Consequently, scattering of light in the light-transmitting portion 300 is reduced, and the visibility through the photoelectric conversion module 1000 is improved. In terms of improving the visibility, the light-transmitting insulating material included in the light-transmitting layer 30 is desirably a material whose refractive index is not greatly different from that of the material of the light-transmitting insulating substrate 21.

The light-transmitting layer 30 may have a transmittance of, for example, 50% or more, or 80% or more. The wavelength of light the light-transmitting layer 30 is expected to transmit depends on an absorption wavelength of the photoelectric conversion layer 23. The light-transmitting layer 30 has, for example, a thickness of 1 nm or more and 1000 nm or less.

### (Light-transmitting insulating substrate)

For example, a glass substrate or a plastic substrate can be used as the light-transmitting insulating substrate 100. The light-transmitting insulating substrate 100 may be a glass substrate. In this case, the visibility through the photoelectric conversion module 1000 can be improved further. Glass for windows may be used as the glass substrate. By using glass for windows as the light-transmitting insulating substrate 100, the photoelectric conversion module 1000 can be used as a window material.

The light-transmitting insulating substrate 100 supports the layers included in the photoelectric conversion module 1000. A thickness of the light-transmitting insulating substrate 100 is not limited to a particular thickness as long as the light-transmitting insulating substrate 100 has a thickness sufficient to ensure enough strength to support the layers.

### (Light-transmitting electrode)

The light-transmitting electrode 21 has electrical conductivity.

In the case where the electron transport layer is not provided, the light-transmitting electrode 21 is formed of a material incapable of forming an ohmic contact with the photoelectric conversion layer 23. Moreover, the light-transmitting electrode 21 has a property of blocking holes from the photoelectric conversion layer 23. The property of blocking holes from the photoelectric conversion layer 23 is a property of allowing only electrons formed in the photoelectric conversion layer 23 to pass and not allowing holes to pass. The material having such a property is a material whose Fermi energy is higher than the energy at an upper part of the valence band of the photoelectric conversion layer 23. The material may be a material whose Fermi energy is higher than the Fermi energy of the photoelectric conversion layer 23.

In the case where the electron transport layer is provided, the light-transmitting electrode 21 does not necessarily have the property of blocking holes from the photoelectric conversion layer 23. That is, the material of the light-transmitting electrode 21 may be a material capable of forming an ohmic contact with the photoelectric conversion layer 23.

The light-transmitting electrode 21 transmits, for example, 10% or more of light with a wavelength in the range from 200 nm to 2000 nm. The light-transmitting electrode 21 can transmit, for example, light from the visible region to the near-IR region. The light-transmitting electrode 21 can be formed of at least one of a transparent electrically conductive metal oxide and a transparent electrically conductive metal nitride.

Examples of the metal oxide include:
(i) a titanium oxide doped with at least one selected from the group consisting of lithium, magnesium, niobium, and fluorine;
(ii) a gallium oxide doped with at least one selected from the group consisting of tin and silicon;
(iii) an indium-tin composite oxide;
(iv) a tin oxide doped with at least one selected from the group consisting of antimony and fluorine; and
(v) a zinc oxide doped with at least one selected from the group consisting of boron, aluminum, gallium, and indium.

Two or more metal oxides can be used in combination as a composite.

Examples of the metal nitride include a gallium nitride doped with at least one selected from the group consisting of silicon and oxygen. Two or more metal nitrides can be used in combination.

The metal oxide and the metal nitride can be used in combination.

The light-transmitting electrode 21 may have a transmittance of, for example, 50% or more, or 80% or more. The wavelength of light the light-transmitting electrode 21 is expected to transmit depends on the absorption wavelength of the photoelectric conversion layer 23. The light-transmitting electrode 21 has, for example, a thickness of 1 nm or more and 1000 nm or less.

### (Electron transport layer)

The electron transport layer includes a semiconductor. The electron transport layer may be a semiconductor having a band gap of 3.0 eV or more. When the electron transport layer is formed of a semiconductor having a band gap of 3.0 eV or more, transmission of visible light and infrared light to the photoelectric conversion layer 23 can be achieved. Examples of the semiconductor include an organic n-type semiconductor and an inorganic n-type semiconductor.

Examples of the organic n-type semiconductor include an imide compound, a quinone compound, fullerene (e.g., C60), a derivative of fullerene, and a phenanthroline derivative (e.g., BCP (2,9-dimethyl-4,7-diphenyl-1,10-phenanthroline, 4,7-diphenyl-2,9-dimethyl-1,10-phenanthrolin)). Examples of the inorganic n-type semiconductor include a metal oxide, a metal nitride, and a perovskite oxide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. A specific example of the metal oxide is TiO₂. The perovskite oxide is, for example, SrTiO₃ or CaTiOs.

The electron transport layer may include a substance having a band gap of more than 6.0 eV. Examples of the substance having a band gap of more than 6.0 eV include:
(i) a halide, such as lithium fluoride or calcium fluoride, of an alkali metal and an alkaline earth metal;
(ii) an alkali metal oxide, such as magnesium oxide; and
(iii) silicon dioxide.
In this case, the electron transport layer has a thickness of, for example, 10 nm or less to secure its electron transport capability.

The electron transport layer may include a plurality of layers formed of different materials from each other.

### (Porous layer)

The porous layer serves as a foothold for formation of the photoelectric conversion layer 23. The porous layer does not prevent light absorption by the photoelectric conversion layer 23 and electron transfer from the photoelectric conversion layer 23 to the electron transport layer.

The porous layer includes a porous body. The porous body is, for example, a porous body including continuous insulating particles or continuous semiconductor particles. The insulating particles are, for example, aluminum oxide particles or silicon oxide particles. The semiconductor particles are, for example, inorganic semiconductor particles. The inorganic semiconductor is, for example, a metal oxide (including a perovskite oxide), a metal sulfide, or a metal chalcogenide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. The metal oxide is specifically TiO₂. The perovskite oxide is, for example, SrTiO₃ or CaTiOs. The metal sulfide is, for example, CdS, ZnS, In₂S₃, SnS, PbS, Mo₂ S, WS₂, Sb₂ S₃, Bi₂S₃, ZnCdS₂, or Cu₂S. The metal chalcogenide is, for example, CdSe, CsSe, In₂Se₃, WSe₂, HgS, SnSe, PbSe, or CdTe. A "porous" substance herein refers to a substance having fine pores inside.

A thickness of the porous layer may be 0.01 µm or more and 10 µm or less, or 0.1 µm or more and 1 µm or less. The porous layer may have a large surface roughness. Specifically, a surface roughness factor determined by "effective area/projected area" may be 10 or greater, or 100 or greater. The projected area refers to the area of a shadow behind an object irradiated with light from the front. The effective area refers to the actual surface area of an object. The effective area can be calculated from a volume of an object, the specific surface area of the material of the object, and the bulk density of the material of the object, the volume being determined from the projected area and the thickness of the object. The specific surface area is measured, for example, by a nitrogen adsorption method.

### (Photoelectric conversion layer)

The photoelectric conversion layer 23 converts light to electric charges. Specifically, the photoelectric conversion layer 23 is formed of a material that converts light to electric charges. The photoelectric conversion layer 23 is, for example, a thin-film photoelectric conversion body. The photoelectric conversion layer 23 may include, for example, a perovskite compound. The photoelectric conversion layer 23 including a perovskite compound is easily evaporated with a laser and is easily removed. Moreover, since the photoelectric conversion layer 23 including a perovskite compound has a significantly different thermal properties from those of the light-transmitting electrode 21, the photoelectric conversion layer 23 on the light-transmitting electrode 21 can be easily removed with a laser while the flatness of the surface of the light-transmitting electrode 21 is maintained. Hence, the photoelectric conversion layer 23 including a perovskite compound makes it possible to easily form the light-transmitting layer 30 using the thin film for formation of the light-transmitting electrode 21 and makes it easy to improve the visibility through the photoelectric conversion module 1000.

The perovskite compound included in the photoelectric conversion layer 23 can be represented by a composition formula ABX₃. Here, A is a monovalent cation, B is a divalent cation, and X is a monovalent anion.

Examples of the monovalent cation A include an organic cation and an alkali metal cation.

Examples of the organic cation include a methylammonium cation (CH₃NH₃⁺), a formamidinium cation (HC(NH₂)₂⁺), an ethylammonium cation (CH₃CH₂NH₃⁺), and a guanidinium cation (CH₆N₃⁺).

Examples of the alkali metal cation include a potassium cation (K⁺), a cesium cation (Cs⁺), and a rubidium cation (Rb⁺).

Examples of the divalent cation B include a lead cation (Pb²⁺) and a tin cation (Sn²⁺).

Examples of the monovalent anion X include a halogen anion.

The sites of each of A, B, and X may be occupied by different ions.

The photoelectric conversion layer 23 may have a thickness of 50 nm or more and 10 µm or less.

The photoelectric conversion layer 23 can be formed by an application technique involving a solution, printing, deposition, or the like. The photoelectric conversion layer 23 may be formed by cutting a perovskite compound.

The photoelectric conversion layer 23 may include the perovskite compound represented by the composition formula ABX₃ as its main component. Saying that "the photoelectric conversion layer 23 includes the perovskite compound represented by the composition formula ABX₃ as its main component" herein means that the perovskite compound represented by the composition formula ABX₃ accounts for 90 mass% or more of the photoelectric conversion layer 23. The perovskite compound represented by the composition formula ABX₃ may account for 95 mass% or more of the photoelectric conversion layer 23. The photoelectric conversion layer 23 may consist of the perovskite compound represented by the composition formula ABX₃. The photoelectric conversion layer 23 is required to include the perovskite compound represented by the composition formula ABX₃, and may include a defect or an impurity.

The photoelectric conversion layer 23 may further include an additional compound different from the perovskite compound represented by the composition formula ABX₃. Examples of the additional compound include compounds having a Ruddlesden-Popper layered perovskite structure.

Cadmium telluride, a thin silicon film, amorphous silicon, or the like may be used as the material of the photoelectric conversion layer 23. When cadmium telluride is used as the material of the photoelectric conversion layer 23, the photoelectric conversion layer 23 may have a laminate structure including cadmium sulfide, cadmium telluride, and zinc telluride in this order.

### (Hole transport layer)

The hole transport layer makes it possible to efficiently transfer holes formed in the photoelectric conversion layer 23 to the counter electrode 22. Consequently, an electric current can be efficiently drawn out.

The hole transport layer includes a hole transport material. The hole transport material is a material that transports holes. The hole transport material can be an organic substance or an inorganic semiconductor.

Examples of the organic substance include triphenylamine, triallylamine, phenylbenzidine, phenylenevinylene, tetrathiafulvalene, vinylnaphthalene, vinylcarbazole, thiophene, aniline, pyrrole, carbazole, triptycene, fluorene, azulene, pyrene, pentacene, perylene, acridine, and phthalocyanine.

Typical examples of the organic substance used as the hole transport material include 2,2',7,7'-tetrakis-(N,N-di-p-methoxyphenylamine)9,9'-spirobifluorene (hereinafter may be abbreviated as "spiro-OMeTAD"), poly[bis(4-phenyl)(2,4,6-trimethylphenyl)amine] (which may be hereinafter abbreviated as "PTAA"), poly(3-hexylthiophene-2,5-diyl) (which may be hereinafter abbreviated as "P3HT"), poly(3,4-ethylenedioxythiophene) (which may be hereinafter abbreviated as "PEDOT"), 2-(3,6-dimethoxy-9H-carbazol-9-yl)ethyl]phosphonic acid (which may be hereinafter abbreviated as "MeO-2PACz"), and copper phthalocyanine.

The inorganic semiconductor used as the hole transport material is a p-type semiconductor. Examples of the inorganic semiconductor include Cu₂O, CuGaO₂, CuSCN, Cul, NiOₓ, MoOₓ, V₂O₅, and carbon materials, such as graphene oxide.

The hole transport layer may include a plurality of layers formed of different materials. For example, the hole transport properties of the hole transport layer are improved by stacking a plurality of layers such that the ionization potential (or the HOMO level) of the hole transport layer becomes shallower layer by layer, the plurality of layers being formed of different materials, the plurality of layers having ionization potentials being lower than that of the photoelectric conversion layer 23.

The thickness of the hole transport layer may be 1 nm or more and 1000 nm or less, or 10 nm or more and 50 nm or less. In this case, sufficiently high hole transport properties can be exhibited and a low resistance can be maintained; therefore, highly efficient photovoltaic power generation can be achieved.

### (Counter electrode)

The counter electrode 22 has electrical conductivity. The counter electrode 22 is not necessarily light-transmissive.

In the case where the hole transport layer is not provided, the counter electrode 22 is formed of a material that is not in ohmic contact with the photoelectric conversion layer 23. Moreover, the counter electrode 22 has a property of blocking electrons from the photoelectric conversion layer 23. The property of blocking electrons from the photoelectric conversion layer 23 refers to a property of allowing only holes formed in the photoelectric conversion layer 23 to pass and not allowing electrons to pass. The material having such a property is one having a lower Fermi energy than the energy of the photoelectric conversion layer 23 at a lower part of the conduction band. The above material may be one having a lower Fermi energy than that of the photoelectric conversion layer 23. The material is specifically platinum, gold, or a carbon material such as graphene.

In the case where the hole transport layer is provided, the counter electrode 22 does not necessarily have the property of blocking electrons from the photoelectric conversion layer 23. That is, the material of the counter electrode 22 may be a material that is in ohmic contact with the photoelectric conversion layer 23.

### (Photoelectric conversion module manufacturing method)

The photoelectric conversion module 1000 can be produced, for example, by the following method. The following manufacturing method is an example of the method for the case of forming the light-transmitting layer 30 using the same material as that of the light-transmitting electrode 21.

One example of the manufacturing method according to the present embodiment includes:
forming a laminate on a first principal surface of a light-transmitting insulating substrate such that a light-transmitting electrode is in contact with the first principal surface of the light-transmitting insulating substrate, the laminate having an integrated structure in which a plurality of photoelectric conversion elements each including the light-transmitting electrode, a counter electrode disposed to face the light-transmitting electrode, and a photoelectric conversion layer disposed between the light-transmitting electrode and the counter electrode are electrically connected to each other in series along a first direction; and
forming, in the laminate, at least one band-shaped region that divides the laminate along the first direction, that transmits light, and that extends along the first direction to form at least two photoelectric conversion element groups in parallel with a light-transmitting portion in between along a second direction that is different from the first direction.

In the above manufacturing method, t the light-transmitting portion is composed of a first band-shaped region extending along the first direction, a second band-shaped region facing the first region, and a third band-shaped region disposed between the first region and the second region, the first region and the second region are formed by removing the laminate, and the third region is formed by removing a portion of the laminate excluding the light-transmitting electrode.

The photoelectric conversion module 1000 having, for example, a configuration as shown in FIG. 4 can be manufactured by the above manufacturing method.

The laminate having the integrated structure in which the plurality of photoelectric conversion elements including the light-transmitting electrode, the counter electrode disposed to face a light-transmitting electrode, and the photoelectric conversion layer disposed between the light-transmitting electrode and the counter electrode are electrically connected to each other in series along the first direction may be manufactured by a known method for manufacturing a laminate having such an integrated structure. An appropriate method can be selected from known methods depending on, for example, the material of the photoelectric conversion layer 23.

The above example of the manufacturing method is not the only method for manufacturing the photoelectric conversion module 1000 according to the present embodiment, and the photoelectric conversion module 1000 according to the present embodiment can be manufactured, for example, by other manufacturing methods as shown below (a first modification and a second modification).

A photoelectric conversion module manufacturing method according to the first modification includes:
(A) forming a multilayer film on a first principal surface of a light-transmitting substrate, the multilayer film including a light-transmitting electrode and a photoelectric conversion film formed of a perovskite compound; and
(B) removing the perovskite compound included in the multilayer film with a laser beam to form: a dividing groove extending in a first direction and dividing the photoelectric conversion film; a first photoelectric conversion element group including the photoelectric conversion film; and a second photoelectric conversion element group including the photoelectric conversion film, the first photoelectric conversion element group and the second photoelectric conversion element group being separated by the dividing groove. The first photoelectric conversion element group and the second photoelectric conversion element group are disposed in parallel along a second direction that is different from the first direction. In the (B), the perovskite compound included in the multilayer film is removed such that a bottom face of the dividing groove is formed of the light-transmitting electrode and the first principal surface of the light-transmitting substrate is not exposed.

By the manufacturing method according to the first modification, the light-transmitting layer 30 of the photoelectric conversion module 1000 can be formed using the light-transmitting electrode. Moreover, the light-transmitting layer 30 having a highly smooth surface can be formed by this manufacturing method, making light scattering which greatly decreases the visibility less likely to occur. Hence, the photoelectric conversion module 1000 providing better visibility can be manufactured.

In the (B) of the manufacturing method according to the first modification, the dividing groove may be formed, for example, by removing the perovskite compound with the laser beam to form the first photoelectric conversion element group and the second photoelectric conversion element group each in a strip shape. In this case, the photoelectric conversion module 1000 providing better visibility can be manufactured.

Moreover, in the manufacturing method according to the first modification, when the first photoelectric conversion element group and the second photoelectric conversion element group are each in a strip shape, a longitudinal direction of the strip shape may be parallel to the first direction. In this case, the photoelectric conversion module 1000 providing better visibility can be manufactured.

A photoelectric conversion module manufacturing method according to the second modification includes:
(a) forming a multilayer film including a photoelectric conversion film on a first principal surface of a light-transmitting substrate;
(b) removing a portion of the multilayer film to form: a dividing groove extending along a first direction and dividing the multilayer film; a first photoelectric conversion element group including the photoelectric conversion film; and a second photoelectric conversion element group including the photoelectric conversion film, the first photoelectric conversion element group and the second photoelectric conversion element group being separated by the dividing groove; and
(c) forming a light-transmitting layer on a bottom face of the dividing groove.
The first photoelectric conversion element group and the second photoelectric conversion element group are disposed in parallel along a second direction that is different from the first direction. In the (b), the multilayer film is removed until the first principal surface of the light-transmitting substrate is exposed to the bottom face of the dividing groove. In the (c), the light-transmitting layer is formed on the first principal surface of the light-transmitting substrate, the first principal surface being exposed to the bottom face of the dividing groove.

By the manufacturing method according to the second modification, the light-transmitting layer 30 can be formed using a material different from that of the light-transmitting electrode 21. Therefore, a material that can further improve the visibility can be used as the material of the light-transmitting layer 30. Hence, the photoelectric conversion module 1000 providing better visibility can be manufactured.

In the (b) of the manufacturing method according to the second modification, the dividing groove may be formed by removing a portion of the multilayer film with a laser beam to form the first photoelectric conversion element group and the second photoelectric conversion element group each in a strip shape. Hence, the photoelectric conversion module 1000 providing better visibility can be manufactured.

Moreover, in the manufacturing method according to the second modification, the photoelectric conversion film may be formed of a perovskite compound. This makes it easy to remove the multilayer film with a laser beam, the photoelectric conversion module 1000 providing high visibility can be easily manufactured.

### [Other embodiments]

### (Supplement)

According to the description of the above embodiment, the following techniques are disclosed.

### (Technique 1)

A photoelectric conversion module including:
a light-transmitting insulating substrate;
a plurality of photoelectric conversion element groups including a first photoelectric conversion element group and a second photoelectric conversion element group adjacent to each other, the plurality of photoelectric conversion element groups being disposed on a first principal surface of the light-transmitting insulating substrate; and
a light-transmitting portion disposed between the first photoelectric conversion element group and the second photoelectric conversion element group, wherein
the first photoelectric conversion element group and the second photoelectric conversion element group each include a plurality of photoelectric conversion elements disposed along a first direction, the plurality of photoelectric conversion elements being electrically connected to each other in series,
the plurality of photoelectric conversion element groups are disposed in parallel along a second direction that is different from the first direction,
the light-transmitting portion includes a light-transmitting layer disposed on the first principal surface of the light-transmitting insulating substrate,
the photoelectric conversion element includes a light-transmitting electrode disposed on the first principal surface of the light-transmitting insulating substrate, a counter electrode disposed to face the light-transmitting electrode, and a photoelectric conversion layer disposed between the light-transmitting electrode and the counter electrode,
the light-transmitting portion is composed of a first region in contact with the first photoelectric conversion element group, a second region in contact with the second photoelectric conversion element group, and a third region provided between the first region and the second region, the third region being in contact neither with the first photoelectric conversion element group nor with the second photoelectric conversion element group,
the light-transmitting layer is disposed neither in the first region nor in the second region, and
the light-transmitting layer is disposed in the third region.

The photoelectric conversion module according to Technique 1 configured as described above can be based on a conventional integration style that can achieve high power and can provide improved visibility.

### (Technique 2)

The photoelectric conversion module according to Technique 1, wherein the light-transmitting layer is formed of the same material as that of the light-transmitting electrode.

This configuration makes it possible to easily form the light-transmitting layer.

### (Technique 3)

The photoelectric conversion module according to Technique 1 or 2, wherein
the first region is a region from an end face of the counter electrode of the first photoelectric conversion element group to a position 20 µm or more apart from the end face, the end face facing the first region, and
the second region is a region from an end face of the counter electrode of the second photoelectric conversion element group to a position 20 µm or more apart from the end face, the end face facing the second region.

This configuration makes it possible to achieve more highly reliable isolation between the first photoelectric conversion element group and the second photoelectric conversion element group. Hence, the photoelectric conversion module according to Technique 3 can achieve higher reliability in addition to improved visibility.

### (Technique 4)

The photoelectric conversion module according to Technique 3, wherein
the first region is a region from the end face of the counter electrode of the first photoelectric conversion element group to a position 1 mm or less apart from the end face, the end face facing the first region, and
the second region is a region from the end face of the counter electrode of the second photoelectric conversion element group to a position 1 mm or less apart from the end face, the end face facing the second region.

This configuration makes it possible for the photoelectric conversion module according to Technique 4 to provide more improved visibility.

### (Technique 5)

The photoelectric conversion module according to any one of Techniques 1 to 4, wherein the first photoelectric conversion element group and the second photoelectric conversion element group are electrically connected to each other in parallel.

In the case of this configuration, even when either the first photoelectric conversion element group or the second photoelectric conversion element group includes a defective photoelectric conversion element, a decrease in power output of the whole module can be reduced by connecting that photoelectric conversion element group to the other photoelectric conversion element group formed of good photoelectric conversion elements in parallel.

### (Technique 6)

The photoelectric conversion module according to any one of Techniques 1 to 5, wherein the photoelectric conversion layer includes a perovskite compound.

This configuration makes it possible to easily form the light-transmitting layer using a thin film for formation of the light-transmitting electrode and makes it easy to improve the visibility through the photoelectric conversion module.

### (Technique 7)

The photoelectric conversion module according to any one of Techniques 1 to 6, wherein the light-transmitting insulating substrate is a glass substrate.

This configuration makes it possible for the photoelectric conversion module according to Technique 7 to provide more improved visibility.

### (Technique 8)

The photoelectric conversion module according to Technique 7, wherein the glass substrate is glass for windows.

This configuration makes it possible to use the photoelectric conversion module according to Technique 8 as a window material.

### (Technique 9)

A photoelectric conversion module manufacturing method including:
forming a laminate on a first principal surface of a light-transmitting insulating substrate such that a light-transmitting electrode is in contact with the first principal surface of the light-transmitting insulating substrate, the laminate having an integrated structure in which a plurality of photoelectric conversion elements each including the light-transmitting electrode, a counter electrode disposed to face the light-transmitting electrode, and a photoelectric conversion layer disposed between the light-transmitting electrode and the counter electrode are electrically connected to each other in series along a first direction; and
forming, in the laminate, at least one band-shaped region that divides the laminate along the first direction, that transmits light, and that extends along the first direction to form at least two photoelectric conversion element groups in parallel with a light-transmitting portion in between in a second direction that is different from the first direction, wherein
the light-transmitting portion is composed of a first band-shaped region extending along the first direction, a second band-shaped region facing the first region, and a third band-shaped region disposed between the first region and the second region, the first region and the second region are formed by removing the laminate, and the third region is formed by removing a portion of the laminate excluding the light-transmitting electrode.

A photoelectric conversion module based on a conventional integration style that can achieve high power output and capable of providing improved visibility can be manufactured by this method.

### (Technique 10)

A photoelectric conversion module manufacturing method including:
(A) forming a multilayer film on a first principal surface of a light-transmitting substrate, the multilayer film including a light-transmitting electrode and a photoelectric conversion film formed of a perovskite compound; and s
(B) removing the perovskite compound included in the multilayer film with a laser beam to form: a dividing groove extending in a first direction and dividing the photoelectric conversion film; a first photoelectric conversion element group including the photoelectric conversion film; and a second photoelectric conversion element group including the photoelectric conversion film, the first photoelectric conversion element group and the second photoelectric conversion element group being separated by the dividing groove, wherein

the first photoelectric conversion element group and the second photoelectric conversion element group are disposed in parallel along a second direction that is different from the first direction, and
in the (B), the perovskite compound included in the multilayer film is removed such that a bottom face of the dividing groove is formed of the light-transmitting electrode and the first principal surface of the light-transmitting substrate is not exposed.

A photoelectric conversion module based on a conventional integration style that can achieve high power output and capable of providing improved visibility can be manufactured by this method.

### (Technique 11)

The photoelectric conversion module manufacturing method according to Technique 10, wherein in the (B), the dividing groove is formed by removing the perovskite compound with the laser beam to form the first photoelectric conversion element group and the second photoelectric conversion element group each in a strip shape.

A photoelectric conversion module based on a conventional integration style that can achieve high power output and capable of providing more improved visibility can be manufactured by this method.

### (Technique 12)

The photoelectric conversion module manufacturing method according to Technique 11, wherein a longitudinal direction of the strip shape is parallel to the first direction.

A photoelectric conversion module based on a conventional integration style that can achieve high power output and capable of providing more improved visibility can be manufactured by this method.

### (Technique 13)

A photoelectric conversion module manufacturing method including:
(a) forming a multilayer film including a photoelectric conversion film on a first principal surface of a light-transmitting substrate;
(b) removing a portion of the multilayer film to form: a dividing groove extending along a first direction and dividing the multilayer film; a first photoelectric conversion element group including the photoelectric conversion film; and a second photoelectric conversion element group including the photoelectric conversion film, the first photoelectric conversion element group and the second photoelectric conversion element group being separated by the dividing groove; and
(c) forming a light-transmitting layer on a bottom face of the dividing groove, wherein

the first photoelectric conversion element group and the second photoelectric conversion element group are disposed in parallel along a second direction that is different from the first direction,
in the (b), the multilayer film is removed until the first principal surface of the light-transmitting substrate is exposed to the bottom face of the dividing groove, and
in the (c), the light-transmitting layer is formed on the first principal surface of the light-transmitting substrate, the first principal surface being exposed to the bottom face of the dividing groove.

A photoelectric conversion module based on a conventional integration style that can achieve high power output and capable of providing improved visibility can be manufactured by this method.

### (Technique 14)

The photoelectric conversion module manufacturing method according to Technique 13, wherein in the (b), the dividing groove is formed by removing a portion of the multilayer film with a laser beam to form the first photoelectric conversion element group and the second photoelectric conversion element group each in a strip shape.

A photoelectric conversion module based on a conventional integration style that can achieve high power output and capable of providing more improved visibility can be manufactured by this method.

### (Technique 15)

The photoelectric conversion module manufacturing method according to Technique 14, wherein the photoelectric conversion film is formed of a perovskite compound.

According to this method, the multilayer film is easily removed with the laser beam, and thus the photoelectric conversion module providing improved visibility can be easily manufactured.

### EXAMPLES

The present disclosure will be described hereinafter in more details with reference to an example and a comparative example.

Here, a sample having a configuration different from the photoelectric conversion module according to the present disclosure was produced as an evaluation sample for examining a difference in visibility attributable to the presence or absence of the light-transmitting layer.

A laminate having, as shown in FIG. 3, an integrated structure in which photoelectric conversion elements were electrically connected to each other in series along a first direction was produced on a glass substrate. The laminate was produced by the following method.

First, a thin film for light-transmitting electrode formation was formed on one principal surface of a 150 mm-square and 0.7 mm-thick glass substrate. Next, first dividing grooves 24 dividing the thin film for light-transmitting electrode formation into twenty-four light-transmitting electrodes 21 were formed on the thin film for light-transmitting electrode formation using a laser.

An indium tin oxide (ITO) film as the thin film for light-transmitting electrode formation was produced on one surface of the above glass substrate as a light-transmitting insulating substrate 100 by sputtering to have a sheet resistance of 10 Ω/sq. and a thickness of 250 nm.

Next, first dividing grooves 24 each having a width of 40 µm were formed by moving the light-transmitting insulating substrate 100 at 300 mm/sec under focused irradiation of the above thin film for light-transmitting electrode formation with a laser beam. A distance between each pair of the adjacent first dividing grooves 24 was 5 mm. The thin film for light-transmitting electrode formation was divided by the first dividing groove 24 to form a light-transmitting electrode 21.

Next, an electron transport layer, a photoelectric conversion layer 23, and a hole transport layer were formed on the light-transmitting electrode 21. The material of the electron transport layer was SnO₂. The material of the photoelectric conversion layer 23 was a CH₃NH₃PbI₃ perovskite compound. The material of the hole transport layer was PTAA. Specifically, an SnO₂ layer, a CH₃NH₃PbI₃ perovskite compound layer, and a PTAA layer were formed on the light-transmitting electrode 21. Note that by the formation process, the multilayer film composed of the SnO₂ layer, the CH₃NH₃PbI₃ perovskite compound layer, and the PTAA layer was formed also in the first dividing groove 24. Subsequently, second dividing grooves 25 dividing the multilayer film into twenty-four photoelectric conversion layers were formed in the multilayer film using a laser. Specifically, second dividing grooves 25 each having a width of 80 µm were formed by moving the light-transmitting insulating substrate 100 at 300 mm/sec under focused irradiation of the multilayer film with a laser beam. By dividing the multilayer film by the second dividing groove 25, the electron transport layer, the photoelectric conversion layer 23, and the hole transport layer were formed.

Next, an indium tin oxide (ITO) film as a counter electrode was formed on the hole transport layer by spattering. The ITO film had a sheet resistance of 15 Ω/sq. and a thickness of 300 nm. Note that by the formation process, the material for counter electrode formation was embedded in the second dividing groove 25. Subsequently, third dividing grooves 26 each having a width of 40 µm were formed on the thin film for counter electrode formation by moving the light-transmitting insulating substrate 100 at 300 mm/sec under focused irradiation of the thin film for counter electrode formation with a laser beam so as to divide the thin film for counter electrode formation into twenty-four counter electrodes.

By the above method, a laminate having an integrated structure in which photoelectric conversion elements were electrically connected to each other in series along the first direction was produced on the glass substrate. Then, dividing grooves were formed in the laminate along the first direction using a laser to divide the laminate into thirty photoelectric conversion element groups. The thirty photoelectric conversion element groups were disposed in parallel in a second direction orthogonal to the first direction.

By the above method, a photoelectric conversion module in which thirty photoelectric conversion element groups were disposed on a glass substrate in parallel in the second direction was produced.

Next, the photoelectric conversion layer and the counter electrode in a first band-shaped region extending along the second direction were removed from the photoelectric conversion module using a laser to leave only the light-transmitting electrode. The laser light source used and the irradiation conditions were the same as those in the production conditions for the second dividing groove 25.

Moreover, the light-transmitting electrode, the photoelectric conversion layer, and the counter electrode in a second band-shaped region extending along the second direction were removed from the photoelectric conversion module using a laser. The laser light source used and the irradiation conditions were the same as those in the production conditions for the first dividing groove 24.

The photoelectric conversion module provided with these two band-shaped regions, namely, the first band-shaped region and the second band-shaped region, was used as an evaluation sample for evaluation of the visibility.

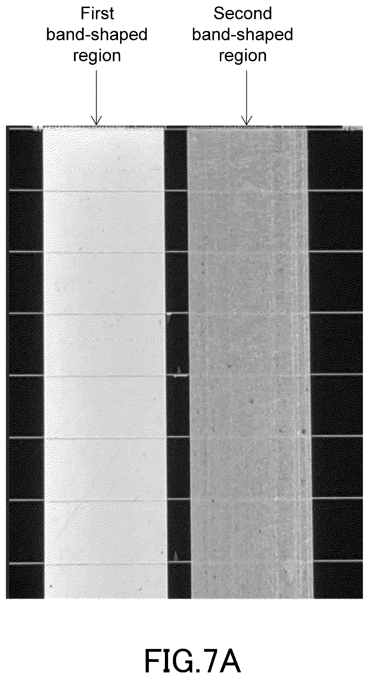

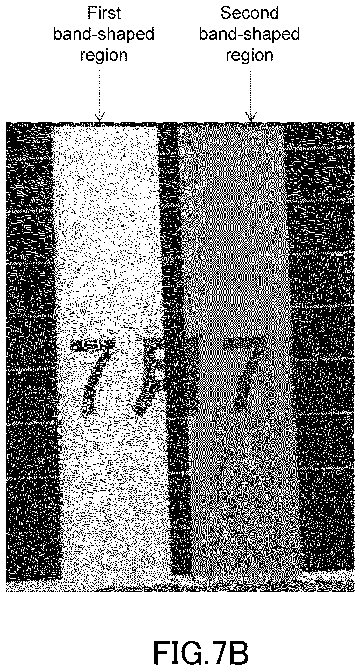

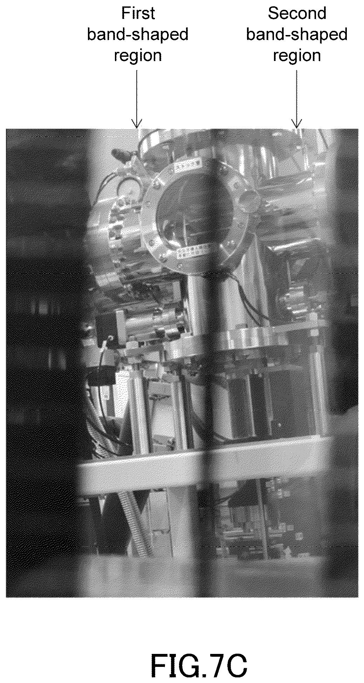

FIG. 7A is an image of transmitting light through the first band-shaped region and the second band-shaped region of the evaluation sample on a light-emitting panel. FIG. 7B is an image of the evaluation sample on a printed material on a light-emitting panel. FIG. 7C is an image of a view on the other side of the evaluation sample through the evaluation sample.

As can be understood from all images shown in FIGS. 7A, 7B, and 7C, it has been confirmed that the first band-shaped region where the light-transmitting electrode remains as the light-transmitting layer provides high visibility, compared to the second band-shaped region provided with no light-transmitting layer.

According to the above result, the photoelectric conversion module according to the present disclosure including the light-transmitting portion provided with the light-transmitting layer can improve the visibility.

### INDUSTRIAL APPLICABILITY

The photoelectric conversion module according to the present disclosure is useful as a building-integrated photoelectric conversion module configured to be installed as a construction material, such as a window material, requiring daylighting.

## Claims

1. A photoelectric conversion module comprising:
a light-transmitting insulating substrate;
a plurality of photoelectric conversion element groups including a first photoelectric conversion element group and a second photoelectric conversion element group adjacent to each other, the plurality of photoelectric conversion element groups being disposed on a first principal surface of the light-transmitting insulating substrate; and
a light-transmitting portion disposed between the first photoelectric conversion element group and the second photoelectric conversion element group, wherein
the first photoelectric conversion element group and the second photoelectric conversion element group each include a plurality of photoelectric conversion elements disposed along a first direction, the plurality of photoelectric conversion elements being electrically connected to each other in series,
the plurality of photoelectric conversion element groups are disposed in parallel along a second direction that is different from the first direction,
the light-transmitting portion includes a light-transmitting layer disposed on the first principal surface of the light-transmitting insulating substrate,
the photoelectric conversion element includes a light-transmitting electrode disposed on the first principal surface of the light-transmitting insulating substrate, a counter electrode disposed to face the light-transmitting electrode, and a photoelectric conversion layer disposed between the light-transmitting electrode and the counter electrode,
the light-transmitting portion is composed of a first region in contact with the first photoelectric conversion element group, a second region in contact with the second photoelectric conversion element group, and a third region provided between the first region and the second region, the third region being in contact neither with the first photoelectric conversion element group nor with the second photoelectric conversion element group,
the light-transmitting layer is disposed neither in the first region nor in the second region, and
the light-transmitting layer is disposed in the third region.

2. The photoelectric conversion module according to claim 1, wherein the light-transmitting layer is formed of the same material as that of the light-transmitting electrode.

3. The photoelectric conversion module according to claim 1 or 2, wherein
the first region is a region from an end face of the counter electrode of the first photoelectric conversion element group to a position 20 µm or more apart from the end face, the end face facing the first region, and
the second region is a region from an end face of the counter electrode of the second photoelectric conversion element group to a position 20 µm or more apart from the end face, the end face facing the second region.

4. The photoelectric conversion module according to claim 3, wherein
the first region is a region from the end face of the counter electrode of the first photoelectric conversion element group to a position 1 mm or less apart from the end face, the end face facing the first region, and
the second region is a region from the end face of the counter electrode of the second photoelectric conversion element group to a position 1 mm or less apart from the end face, the end face facing the second region.

5. The photoelectric conversion module according to any one of claims 1 to 4, wherein the first photoelectric conversion element group and the second photoelectric conversion element group are electrically connected to each other in parallel.

6. The photoelectric conversion module according to any one of claims 1 to 5, wherein the photoelectric conversion layer includes a perovskite compound.

7. The photoelectric conversion module according to any one of claims 1 to 6, wherein the light-transmitting insulating substrate is a glass substrate.

8. The photoelectric conversion module according to claim 7, wherein the glass substrate is formed of glass for windows.

9. A photoelectric conversion module manufacturing method comprising:
forming a laminate on a first principal surface of a light-transmitting insulating substrate such that a light-transmitting electrode is in contact with the first principal surface of the light-transmitting insulating substrate, the laminate having an integrated structure in which a plurality of photoelectric conversion elements each including the light-transmitting electrode, a counter electrode disposed to face the light-transmitting electrode, and a photoelectric conversion layer disposed between the light-transmitting electrode and the counter electrode are electrically connected to each other in series along a first direction; and
forming, in the laminate, at least one band-shaped region that divides the laminate along the first direction, that transmits light, and that extends along the first direction to form at least two photoelectric conversion element groups in parallel with a light-transmitting portion in between in a second direction that is different from the first direction, wherein
the light-transmitting portion is composed of a first band-shaped region extending along the first direction, a second band-shaped region facing the first region, and a third band-shaped region disposed between the first region and the second region, the first region and the second region are formed by removing the laminate, and the third region is formed by removing a portion of the laminate excluding the light-transmitting electrode.

10. A photoelectric conversion module manufacturing method comprising:
(A) forming a multilayer film on a first principal surface of a light-transmitting substrate, the multilayer film including a light-transmitting electrode and a photoelectric conversion film formed of a perovskite compound; and
(B) removing the perovskite compound included in the multilayer film with a laser beam to form: a dividing groove extending in a first direction and dividing the photoelectric conversion film; a first photoelectric conversion element group including the photoelectric conversion film; and a second photoelectric conversion element group including the photoelectric conversion film, the first photoelectric conversion element group and the second photoelectric conversion element group being separated by the dividing groove, wherein
the first photoelectric conversion element group and the second photoelectric conversion element group are disposed in parallel along a second direction that is different from the first direction, and
in the (B), the perovskite compound included in the multilayer film is removed such that a bottom face of the dividing groove is formed of the light-transmitting electrode and the first principal surface of the light-transmitting substrate is not exposed.

11. The photoelectric conversion module manufacturing method according to claim 10, wherein in the (B), the dividing groove is formed by removing the perovskite compound with the laser beam to form the first photoelectric conversion element group and the second photoelectric conversion element group each in a strip shape.

12. The photoelectric conversion module manufacturing method according to claim 11, wherein a longitudinal direction of the strip shape is parallel to the first direction.

13. A photoelectric conversion module manufacturing method comprising:
(a) forming a multilayer film including a photoelectric conversion film on a first principal surface of a light-transmitting substrate;
(b) removing a portion of the multilayer film to form: a dividing groove extending along a first direction and dividing the multilayer film; a first photoelectric conversion element group including the photoelectric conversion film; and a second photoelectric conversion element group including the photoelectric conversion film, the first photoelectric conversion element group and the second photoelectric conversion element group being separated by the dividing groove; and
(c) forming a light-transmitting layer on a bottom face of the dividing groove, wherein
the first photoelectric conversion element group and the second photoelectric conversion element group are disposed in parallel along a second direction that is different from the first direction,
in the (b), the multilayer film is removed until the first principal surface of the light-transmitting substrate is exposed to the bottom face of the dividing groove, and
in the (c), the light-transmitting layer is formed on the first principal surface of the light-transmitting substrate, the first principal surface being exposed to the bottom face of the dividing groove.

14. The photoelectric conversion module manufacturing method according to claim 13, wherein in the (b), the dividing groove is formed by removing a portion of the multilayer film with a laser beam to form the first photoelectric conversion element group and the second photoelectric conversion element group each in a strip shape.

15. The photoelectric conversion module manufacturing method according to claim 14, wherein the photoelectric conversion film is formed of a perovskite compound.
